# EUROPEAN PATENT APPLICATION

(11) **EP 4 307 349 A1**
(43) Date of publication of application: **17.01.2024**
(21) Application number: 22766773.0
(22) Date of filing: 17.02.2022
(51) Int. Cl.: H01L 21/3065

(54) **ETCHING GAS AND ETCHING METHOD**

(30) Priority: 09.03.2021 JP 2021037642
(71) Applicant: Resonac Corporation, Tokyo 105-8518 (JP)
(72) Inventor: IWASAKI, Jumpei, Tokyo 105-8518 (JP); TANIMOTO, Yosuke, Tokyo 105-8518 (JP)
(74) Representative: Strehl Schübel-Hopf & Partner
(86) International application number: PCT/JP2022/006377
(87) International publication number: WO 2022/190809

(57) **Abstract**

Provided are an etching gas and an etching method, which are capable of selectively etching an etching object having silicon nitride in comparison with a non-etching object. The etching gas contains nitrosyl fluoride and also contains nitryl fluoride as an impurity, in which the concentration of nitryl fluoride is 0.0001 ppm by mass or more and 100 ppm by mass or less. The etching method includes an etching step of bringing this etching gas into contact with a member to be etched (12) having an etching object, which is an object of etching by the etching gas, and a non-etching object, which is not an object to be etched by the etching gas, and selectively etching the etching object in comparison with the non-etching object. The etching object has silicon nitride.

## Description

### Technical Field

The present invention relates to an etching gas and a method for producing the same, an etching method, and a method for producing a semiconductor element.

### Background Art

Silicon nitride is a material used for semiconductor devices such as flash memory; however, there is a problem that silicon nitride has low etching selectivity (performance enabling silicon nitride to be selectively etched in comparison with other silicon materials) when etched from other silicon materials such as silicon oxide. Regarding an etching method for solving this problem, dry etching may be used, and above all, dry etching using nitrosyl fluoride (NOF) as an etching gas exhibits high etching selectivity when etching silicon nitride from silicon oxide.

That is, in a case where an etching object, which is an object of etching using an etching gas, is silicon nitride, and a non-etching object, which is not an object of etching using an etching gas, is silicon oxide, when etching is performed by dry etching using nitrosyl fluoride as an etching gas, it is possible to selectively etch silicon nitride, which is the etching object, in comparison with silicon oxide, which is a non-etching object.

For example, PTL 1 discloses a method for producing a semiconductor element for use in 3D-NAND type device applications, by performing dry etching using nitrosyl fluoride as an etching gas. In this production method, a silicon nitride layer of a laminate in which silicon nitride films and silicon oxide films are alternately laminated, is subjected to horizontal isotropic etching by performing dry etching using nitrosyl fluoride as an etching gas.

### Citation List

### Patent Literature

PTL 1: US 10529581 B

### Summary of Invention

### Technical Problem

However, in the dry etching disclosed in PTL 1, there are occasions in which the etching selectivity is insufficient, and therefore, further improvement of the etching selectivity has been required.

It is an object of the present invention to provide an etching gas capable of selectively etching an etching object having silicon nitride in comparison with a non-etching object, a method for producing the etching gas, an etching method, and a method for producing a semiconductor element.

### Solution to Problem

In order to solve the above-described problems, an aspect of the present invention is as shown in the following aspects [1] to [6].
[1] An etching gas containing nitrosyl fluoride, in which the etching gas contains nitryl fluoride as an impurity and has a concentration of nitryl fluoride of 0.0001 ppm by mass or more and 100 ppm by mass or less.
[2] A method for producing the etching gas according to [1], the method having a nitryl fluoride removal step of subjecting crude nitrosyl fluoride, which is nitrosyl fluoride containing nitryl fluoride, to a nitryl fluoride removal treatment of removing nitryl fluoride.
[3] An etching method including an etching step of bringing the etching gas according to [1] into contact with a member to be etched having an etching object, which is an object of etching by the etching gas, and a non-etching object, which is not an object of etching by the etching gas, and selectively etching the etching object in comparison with the non-etching object, in which the etching object contains silicon nitride.
[4] The etching method according to [3], in which the etching gas is a gas consisting of nitrosyl fluoride alone, or a mixed gas containing nitrosyl fluoride and a diluent gas.
[5] The etching method according to [4], in which the diluent gas is at least one selected from nitrogen gas, helium, argon, neon, krypton, and xenon.
[6] A method for producing a semiconductor element for producing a semiconductor element using the etching method according to any one of [3] to [5], in which
   the member to be etched is a semiconductor substrate having the etching object and the non-etching object, and
   the method includes a treatment step of removing at least a portion of the etching object from the semiconductor substrate by the etching.

### Advantageous Effects of Invention

According to the present invention, it is possible to selectively etch an etching object having silicon nitride in comparison with a non-etching object.

### Brief Description of Drawings

FIG. 1 is a schematic view of an example of an etching apparatus, illustrative of an embodiment of the etching method according to the present invention; and
FIG. 2 is a view illustrative of a member to be etched used in Examples and Comparative Examples.

### Description of Embodiments

An embodiment of the present invention will now be described. The present embodiment is to show an example of the present invention, and the present invention is not limited to the present embodiment. Furthermore, various modifications or improvements can be made in the present embodiment, and forms to which such modifications or improvements can be encompassed by in the present invention.

The etching gas according to the present embodiment is an etching gas containing nitrosyl fluoride (NOF), the etching gas containing nitryl fluoride (NO₂F) as an impurity and has a concentration of nitryl fluoride of 0.0001 ppm by mass or more and 100 ppm by mass or less.

The etching method according to the present embodiment includes an etching step of bringing an etching gas according to the above-described present embodiment into contact with a member to be etched having an etching object, which is an object of etching by the etching gas, and a non-etching object, which is not an object of etching by the etching gas, and selectively etching the etching object in comparison with the non-etching object. In the etching method according to the present embodiment, the etching object has silicon nitride (SiN).

When an etching gas is brought into contact with a member to be etched, an etching object containing silicon nitride reacts with nitrosyl fluoride in the etching gas, and thereby etching of the etching object proceeds. In contrast, since a non-etching object such as a resist or a mask hardly react with nitrosyl fluoride, etching of the non-etching object hardly proceeds. Thus, according to the etching method according to the present embodiment, it is possible to selectively etch an etching object in comparison with a non-etching object (that is, high etching selectivity is obtained). Furthermore, according to the etching method according to the present embodiment, it is possible to etch an etching object containing silicon nitride at a high etching rate.

However, the nitryl fluoride reacts with both the etching object containing silicon nitride and the non-etching object such as a resist or a mask. Therefore, when etching of a member to be etched is performed by using an etching gas containing nitryl fluoride, there is concern that both the etching object and the non-etching object are etched, and the etching selectivity may be insufficient. Therefore, in order to increase the etching selectivity, it is necessary to lower the concentration of nitryl fluoride in the etching gas.

That is, the concentration of nitryl fluoride in the etching gas needs to be 100 ppm by mass or less, and the concentration is preferably 50 ppm by mass or less, and more preferably 10 ppm by mass or less. When etching is performed by using an etching gas having a concentration of nitryl fluoride in the above-described range, the non-etching object is less likely to be etched, and therefore, the etching selectivity for the etching object with respect to the non-etching object is increased. A method for measuring the concentration of nitryl fluoride is not particularly limited; however, for example, when measurement is made by infrared spectroscopy, it is possible to quantitatively measure the concentration by means of the intensity of a peak at a wave number of 1,324 cm⁻¹ in the obtained infrared absorption spectrum.

As described above, since the etching gas according to the present embodiment has a low concentration of nitryl fluoride, when etching of a member to be etched is performed by using the etching gas according to the present embodiment, the non-etching object is less likely to be etched, it is possible to selectively etch the etching object in comparison with the non-etching object, and the etching selectivity is increased.

For example, it is possible to adjust the etching selectivity ratio, which is the ratio of the etching rate of the etching object with respect to the etching rate of the non-etching object, to be 60 or more. The etching selectivity ratio is preferably 60 or more, more preferably 100 or more, and even more preferably 200 or more.

Here, the reason why the etching selectivity of silicon nitride with respect to silicon oxide is increased when etching of a member to be etched is performed using an etching gas containing nitrosyl fluoride, will be described below.

First, when plasma or heat is applied, nitrosyl fluoride is dissociated into NO radical (NO•) and fluorine radical (F•), and then when plasma or heat is further applied, the NO radical changes to activated NO in an excited state (NO*) (see the following Formula (1)). NO* reacts with SiN present on the surface of silicon nitride, and the generation of Si in an excited state (Si*) having a dangling bond proceeds (see the following Formula (2)). The reaction of Formula (2) is an exothermic reaction, and the reaction proceeds spontaneously.

NOF → NO• + F• → NO* + F• ··· (1)

SiN + NO* -> Si* + N₂O ··· (2)

When Si* generated by the reaction of Formula (2) reacts with F• generated by the reaction of Formula (1) to generate SiF₄, etching proceeds (see the following Formula (3)). On the other hand, since the reaction between SiO present on the surface of silicon oxide and NO* (see the following Formula (4)) is an endothermic reaction, the reaction is less likely to proceed spontaneously in comparison with the reaction of Formula (2) .

Si* + 4F• → SiF_{4↑} ··· (3)

SiO + NO* -> Si* + NO₂ ··· (4)

As described above, regarding NO* generated from nitrosyl fluoride, it is believed that since the reaction with SiN present on the surface of silicon nitride proceeds spontaneously, while the reaction with SiO present on the surface of silicon oxide is less likely to proceed spontaneously, the etching selectivity of silicon nitride is high.

When nitryl fluoride is incorporated into the etching gas, and the concentration of nitryl fluoride is equal to or more than a certain value, the etching selectivity of silicon nitride with respect to silicon oxide is decreased. It is estimated that this is because SiO is generated as the oxygen atom (O) attributable to nitryl fluoride reacts with Si* in the reaction of Formula (3).

Next, the reason why nitryl fluoride is likely to be contained as an impurity in nitrosyl fluoride will be described below. There are various synthesis methods for nitrosyl fluoride; however, generally, a method of reacting nitrogen monoxide (NO) with fluorine gas (F₂) at normal temperature and normal pressure is frequently employed (see the following Formula (5)). In this reaction, impurities are less likely to be generated, and nitrosyl fluoride can be synthesized in high yield; however, nitryl fluoride may be generated as a by-product depending on the reaction conditions (see the following Formula (6)).

2NO + F₂ → 2NOF ··· (5)

4NO + F₂ → 2NO₂F + N₂ ··· (6)

As described above, since nitryl fluoride is likely to be contained as an impurity in nitrosyl fluoride, in the case of producing the etching gas according to the present embodiment containing nitrosyl fluoride, it is necessary to eliminate nitryl fluoride from nitrosyl fluoride in order to lower the concentration of nitryl fluoride.

That is, the method for producing an etching gas according to the present embodiment is a method for producing the etching gas according to the above-described present embodiment, and includes a nitryl fluoride removal step of subjecting crude nitrosyl fluoride, which is nitrosyl fluoride containing nitryl fluoride, to a nitryl fluoride removal treatment of removing nitryl fluoride.

A method for the nitryl fluoride removal treatment of removing nitryl fluoride from the crude nitrosyl fluoride is not particularly limited; however, for example, in a case where impurities are likely to be included in the gas phase portion, a method of extracting and removing the gas phase portion of crude nitrosyl fluoride, a method of distilling crude nitrosyl fluoride and removing nitryl fluoride, a method of bringing crude nitrosyl fluoride into contact with an adsorbent and removing nitryl fluoride, and the like may be mentioned. The temperature of the column bottom (container) of the distillation column into which crude nitrosyl fluoride is charged when distillation is performed is not particularly limited; however, it is preferable to set the temperature to -70°C or higher and -45°C or lower, and more preferably to -60°C or higher and -50°C or lower.

When etching is performed by setting the concentration of nitryl fluoride in the etching gas containing nitrosyl fluoride in the above-described range, it is possible to selectively etch an etching object having silicon nitride in comparison with a non-etching object. In addition, etching according to the present invention means that processing (for example, processing a film-shaped etching object formed from silicon nitride, which is held by the member to be etched, into a predetermined film thickness) a member to be etched into a predetermined shape (for example, a three-dimensional shape) by removing a portion or the entirety of the etching object held by the member to be etched.

It is possible to utilize the etching method according to the present embodiment for the production of a semiconductor element. That is, the method for producing a semiconductor element according to the present embodiment is a method for producing a semiconductor element, by which a semiconductor element is produced by using the etching method according to the present embodiment, in which the member to be etched is a semiconductor substrate having an etching object and a non-etching object, and the method includes a treatment step of removing at least a portion of the etching object from the semiconductor substrate by etching.

Since the etching method according to the present embodiment is capable of accurately etching an etching object, it is possible to use the etching method for, for example, the production of semiconductor elements such as 3D-NAND type flash memory and logic devices. Furthermore, it is expected that the etching method according to the present embodiment will contribute to further miniaturization and higher integration of semiconductor elements.

Hereinafter, the etching gas, the method for producing an etching gas, the etching method, and the method for producing a semiconductor element according to the present embodiment will be described in more detail.

### [Etching Gas]

The etching gas is a gas containing nitrosyl fluoride; however, the etching gas may be a gas consisting of nitrosyl fluoride alone (a trace amount of nitryl fluoride is contained as an impurity), or may be a mixed gas containing nitrosyl fluoride and another kind of gas. The concentration of nitrosyl fluoride in the etching gas is preferably 0.3% by volume or more, more preferably 0.5% by volume or more and 50% by volume or less, and even more preferably 2% by volume or more and 30% by volume or less.

When etching is performed by setting the concentration of nitrosyl fluoride in the etching gas in the above-described range, the etching object having silicon nitride is likely to be selectively etched in comparison with the non-etching object, and the etching selectivity is increased. For example, the etching selectivity ratio, which is the ratio of the etching rate of the etching object with respect to the etching rate of the non-etching object, is likely to be 60 or more.

It is possible to use an inert diluent gas as the another kind of gas that constitutes the etching gas together with nitrosyl fluoride gas. That is, it is possible prepare the etching gas to be a mixed gas containing nitrosyl fluoride and a diluent gas.

As the diluent gas, it is possible to use at least one selected from nitrogen gas (N₂), helium (He), neon (Ne), argon (Ar), krypton (Kr), and xenon (Xe).

The concentration of the diluent gas in the etching gas is preferably 99.7% by volume or less, more preferably 50% by volume or more and 99.5% by volume or less, and even more preferably 70% by volume or more and 98% by volume or less.

### [Etching method]

It is possible to achieve the etching according to the present embodiment by either plasma etching that uses plasma or plasmaless etching that uses no plasma. Examples of the plasma etching include Reactive Ion Etching (RIE), Inductively Coupled Plasma (ICP) etching, Capacitively Coupled Plasma (CCP) etching, Electron Cyclotron Resonance (ECR) plasma etching, and microwave plasma etching.

Furthermore, with regard to plasma etching, plasma may be generated in a chamber in which a member to be etched is installed, or a plasma generation chamber and a chamber in which the member to be etched is installed may be separated (that is, remote plasma may be used). Etching using remote plasma may enable an etching object having silicon nitride to be etched with higher selectivity.

### [Pressure conditions for etching step]

The pressure conditions for the etching step in the etching method according to the present embodiment is not particularly limited; however, in the case of plasma etching, it is preferable to set the pressure to 10 Pa or less, and more preferably to 5 Pa or less. When the pressure conditions are in the above-described range, plasma is likely to be stably generated. On the other hand, it is preferable that the pressure conditions for the etching step are 0.05 Pa or more in the case of plasma etching. When the pressure conditions are in the above-described range, a large quantity of ionized ions are generated, and a sufficient plasma density is likely to be obtained.

In the case of plasmaless etching, from the viewpoint of uniformly etching the surface of the member to be etched, the pressure conditions for the etching step are preferably 1 Pa or more and 100 kPa or less, more preferably 100 Pa or more and 80 kPa or less, and even more preferably 1 kPa or more and 60 kPa or less. When the pressure of the etching gas in the chamber is in the above-described range, a sufficient etching rate is obtained, and at the same time, the etching selectivity ratio is likely to be increased. The flow rate of the etching gas may be set appropriately such that the pressure in the chamber is maintained at a constant level, according to the size of the chamber and the capacity of an exhaust facility that depressurizes the inside of the chamber.

### [Temperature conditions for etching step]

The temperature conditions for the etching step in the etching method according to the present embodiment are not particularly limited; however, in the case of plasma etching, it is preferable to set the temperature to 200°C or lower in order to obtain high etching selectivity, it is more preferable to set the temperature to 150°C or lower in order to further suppress etching of the non-etching object, and it is even more preferable to set the temperature to 100°C or lower in order to perform anisotropic etching. Here, the temperature of the temperature conditions is the temperature of the member to be etched; however, it is also possible to use the temperature of a stage installed in the chamber of the etching apparatus for supporting the member to be etched.

In the case of plasmaless etching, it is preferable to set the temperature conditions for the etching step to 40°C or higher and lower than 350°C, more preferably to 70°C or higher and 330°C or lower, and even more preferably to 130°C or higher and 300°C or lower. Within this temperature range, etching of the etching object (in particular, silicon nitride) held by the member to be etched proceeds smoothly, and at the same time, the load on the etching apparatus is small, while the life of the etching apparatus is likely to be lengthened.

### [Treatment time for etching step]

It is possible to set the treatment time for etching (hereinafter, also described as "etching time") to any value according to how much it is wished to etch the etching object held by the member to be etched; however, when considering the production efficiency of the semiconductor element production process, it is preferable to set the treatment time to be within 60 minutes, more preferably within 40 minutes, and even more preferably within 30 minutes. The etching treatment time refers to a time starting from the introduction of the etching gas into the chamber until the exhaustion of the etching gas inside the chamber to finish etching.

### [Bias power of etching step]

The bias power constituting the potential difference between the plasma generated when performing plasma etching and the member to be etched may be selected from 0 to 10000 W depending on the desired etching shape, and in the case of selectively performing etching, the bias power is preferably about 0 to 1000 W. It is possible to perform anisotropic etching by means of this potential difference.

### [Member to be etched]

The member to be etched that is etched by the etching method according to the present embodiment has an etching object and a non-etching object; however, the member to be etched may be a member having a part formed from an etching object and a part formed from a non-etching object, or may be a member formed from a mixture of an etching object and a non-etching object. Furthermore, the member to be etched may also have a part other than the etching object and the non-etching object.

The shape of the member to be etched is not particularly limited and may be, for example, a plate shape, a foil shape, a film shape, a powder shape, or a lump shape. An example of the member to be etched is the above-mentioned semiconductor substrate.

### [Etching object]

The etching object has silicon nitride; however, the etching object may be formed from silicon nitride only, may have a portion formed from silicon nitride only and a portion formed from another material, or may be formed from a mixture of silicon nitride and another material.

Silicon nitride refers to a compound having silicon and nitrogen at any proportions, and an example thereof may be Si₃N₄. The purity of silicon nitride is not particularly limited; however, the purity is preferably 30% by mass or more, more preferably 60% by mass or more, and even more preferably 90% by mass or more.

Furthermore, the shape of the etching object is not particularly limited, and examples include a plate shape, a foil shape, a film shape, a powder shape, and a lump shape.

### [Non-etching object]

A non-etching object does not substantially react with nitrosyl fluoride or reacts extremely slowly with nitrosyl fluoride, and therefore, etching hardly proceeds even when etching is performed by the etching method according to the present embodiment. The non-etching object is not particularly limited as long as it has properties such as described above, and examples thereof include silicon oxide. Examples of the silicon oxide include silicon dioxide (SiO₂).

Furthermore, it is possible to use the non-etching object as a resist or a mask for suppressing etching of the etching object by the etching gas. Therefore, it is possible to utilize the etching method according to the present embodiment as a method such as processing an etching object into a predetermined shape by utilizing a patterned non-etching object as a resist or a mask (for example, a film-shaped etching object held by a member to be etched is processed into a predetermined film thickness), and therefore, it is possible to suitably use the etching method for the production of a semiconductor element. Furthermore, since the non-etching object is hardly etched, it is possible to suppress etching of portions that are originally not to be etched in a semiconductor element, and to prevent the loss of characteristics of the semiconductor element due to etching.

It is possible to remove the non-etching object remaining after patterning by removal methods that are commonly used in a semiconductor element production process. Examples thereof include ashing with oxidative gases such as nitryl fluoride plasma and ozone, and dissolution and removal using liquid chemicals such as APM (a mixed liquid of ammonia water and hydrogen peroxide water), SPM (a mixed liquid of sulfuric acid and hydrogen peroxide water), organic solvents, and the like.

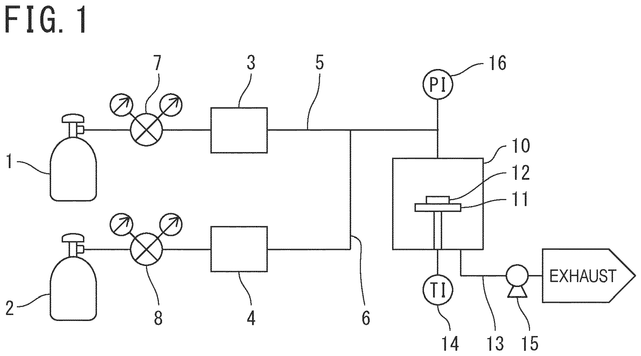

Next, with reference to FIG. 1, an example of a configuration of an etching apparatus capable of implementing the etching method according to the present embodiment and an example of an etching method using the etching apparatus, will be described. The etching apparatus of FIG. 1 is an etching apparatus capable of performing etching using plasma. First, the etching apparatus in FIG. 1 will be described.

The etching apparatus in FIG. 1 includes: a chamber 10 inside which etching is performed; a plasma generator (not illustrated) that generates plasma inside the chamber 10; a stage 11 that supports a member to be etched 12, which is to be etched, inside the chamber 10; a thermometer 14 that measures the temperature of the member to be etched 12; an exhaust pipe 13 for discharging the gas inside the chamber 10; a vacuum pump 15 installed in the exhaust pipe 13 to depressurize the inside of the chamber 10; and a pressure gauge 16 for measuring the pressure inside the chamber 10. When the stage 11 is joined to a high-frequency power supply, it is possible to impart a function of applying a high frequency to the member to be etched 12, to the stage 11.

The type of the plasma generation mechanism of the plasma generator is not particularly limited, and the mechanism may involve application of a high-frequency voltage to parallel plates or may involve passing of a high-frequency current through coils. When a high-frequency voltage is applied to the member to be etched 12 in plasma, a negative voltage is applied to the member to be etched 12, and positive ions are incident to the member to be etched 12 vertically at high speed, so that anisotropic etching is enabled.

The etching apparatus in FIG. 1 is provided with an etching gas supply unit that supplies the etching gas to the inside of the chamber 10. This etching gas supply unit has a nitrosyl fluoride gas supply unit 1 that supplies nitrosyl fluoride gas, a diluent gas supply unit 2 that supplies a diluent gas, a nitrosyl fluoride gas supply pipe 5 that joins the nitrosyl fluoride gas supply unit 1 and the chamber 10, and a diluent gas supply pipe 6 that joins the diluent gas supply unit 2 to an intermediate part of the nitrosyl fluoride gas supply pipe 5.

In addition, the nitrosyl fluoride gas supply pipe 5 is provided with a nitrosyl fluoride gas pressure controller 7 that controls the pressure of nitrosyl fluoride gas, and a nitrosyl fluoride gas flow rate controller 3 that controls the flow rate of nitrosyl fluoride gas. The diluent gas supply pipe 6 is provided with a diluent gas pressure controller 8 that controls the pressure of the diluent gas, and a diluent gas flow rate controller 4 that controls the flow rate of the diluent gas. A facility for supplying an additive gas may also be provided together (not illustrated), in the same configuration as the cases of the diluent gas supply unit 2, the diluent gas flow rate controller 4, the diluent gas supply pipe 6, and the diluent gas pressure controller 8.

Then, when nitrosyl fluoride gas is supplied to the chamber 10 as an etching gas, it is configured such that nitrosyl fluoride gas is supplied to the chamber 10 through the nitrosyl fluoride gas supply pipe 5 by depressurizing the inside of the chamber 10 with the vacuum pump 15, and then sending out the nitrosyl fluoride gas from the nitrosyl fluoride gas supply unit 1 to the nitrosyl fluoride gas supply pipe 5.

Furthermore, when a mixed gas of nitrosyl fluoride gas and a diluent gas such as an inert gas is supplied as an etching gas, the inside of the chamber 10 is depressurized with the vacuum pump 15, and then the nitrosyl fluoride gas is sent out from the nitrosyl fluoride gas supply unit 1 to the nitrosyl fluoride gas supply pipe 5, while at the same time, the diluent gas is sent out from the diluent gas supply unit 2 to the nitrosyl fluoride gas supply pipe 5 through the diluent gas supply pipe 6. As a result, it is configured such that the nitrosyl fluoride gas and the diluent gas are mixed in the intermediate part of the nitrosyl fluoride gas supply pipe 5 to form a mixed gas, and this mixed gas is supplied to the chamber 10 through the nitrosyl fluoride gas supply pipe 5. However, the nitrosyl fluoride gas and the diluent gas may be each separately supplied to the chamber 10 and used as a mixed gas in the chamber 10.

The configuration of the nitrosyl fluoride gas supply unit 1 and the diluent gas supply unit 2 is not particularly limited and may be, for example, a steel bottle or a cylinder. Furthermore, as the nitrosyl fluoride gas flow rate controller 3 and the diluent gas flow rate controller 4, it is possible to utilize, for example, a mass flow controller or a flow meter.

When the etching gas is supplied to the chamber 10, it is preferable to supply the etching gas while maintaining the supply pressure of the etching gas (that is, the value of the nitrosyl fluoride gas pressure controller 7 in FIG. 1) at a predetermined value. That is, the supply pressure of the etching gas is preferably set, in the case of plasma etching, to 1 Pa or more and 0.2 MPa or less, more preferably to 10 Pa or more and 0.1 MPa or less, and even more preferably to 50 Pa or more and 50 kPa or less.

Furthermore, in the case of plasmaless etching, the supply pressure of the etching gas is preferably set to 1 kPa or more and 1.0 MPa or less, more preferably to 5 kPa or more and 0.7 MPa or less, and even more preferably to 10 kPa or more and 0.5 MPa or less.

When the supply pressure of the etching gas is in the above-described range, the supply of the etching gas to the chamber 10 is smoothly achieved, and the load on the parts of the etching apparatus in FIG. 1 (for example, the various devices and pipes described above) is small.

From the viewpoint of uniformly etching the surface of the member to be etched 12, the pressure of the etching gas supplied into the chamber 10 is, in the case of plasma etching, preferably 1 Pa or more and 80 kPa or less, more preferably 10 Pa or more and 50 kPa or less, and even more preferably 100 Pa or more and 20 kPa or less.

In the case of plasmaless etching, the pressure of the etching gas supplied into the chamber 10 is preferably 1 Pa or more and 100 kPa or less, more preferably 100 Pa or more and 80 kPa or less, and even more preferably 1 kPa or more and 60 kPa or less.

When the pressure of the etching gas in the chamber 10 is in the above-described range, a sufficient etching rate is obtained, and at the same time, the etching selectivity ratio is likely to be increased.

The pressure inside the chamber 10 before supplying the etching gas is not particularly limited as long as the pressure is equal to or lower than the supply pressure of the etching gas or a pressure lower than the supply pressure of the etching gas; however, for example, the pressure is preferably 10⁻⁵ Pa or more and less than 10 kPa, and more preferably 1 Pa or more and 2 kPa or less.

The differential pressure between the supply pressure of the etching gas and the pressure inside the chamber 10 before supplying the etching gas is preferably 0.5 MPa or less, more preferably 0.3 MPa or less, and even more preferably 0.1 MPa or less. When the differential pressure is in the above-described range, the supply of the etching gas to the chamber 10 is likely to be smoothly achieved.

When the etching gas is supplied to the chamber 10, it is preferable to supply the etching gas while maintaining the temperature of the etching gas at a predetermined value. That is, the supply temperature of the etching gas is preferably 0°C or higher and 150°C or lower.

It is possible to carry out the etching method according to the present embodiment using a general etching apparatus used in a semiconductor element production process, such as the etching apparatus in FIG. 1, and the configuration of the usable etching apparatus is not particularly limited.

For example, the positional relationship between the nitrosyl fluoride gas supply pipe 5 and the member to be etched 12 is not particularly limited as long as it is possible to bring the etching gas into contact with the member to be etched 12. Furthermore, regarding the configuration of the temperature regulation mechanism of the chamber 10, since it is sufficient when it is capable of regulating the temperature of the member to be etched 12 to any temperature, it may be configured such that a temperature regulation mechanism for the member to be etched 12 is provided directly on the stage 11, or an externally attachable temperature regulator may be used to heat or cool the chamber 10 from the outside of the chamber 10.

The material of the etching apparatus in FIG. 1 is not particularly limited as long as the material has corrosion resistance to the nitrosyl fluoride used and is able to be depressurized to a predetermined pressure. For example, for the portion coming into contact with the etching gas, it is possible to use a metal such as stainless steel, a ceramic such as alumina (Al₂O₃), a fluororesin, or the like.

Examples of the fluororesin include polytetrafluoroethylene (PTFE), polychlorotrifluoroethylene (PCTFE), an ethylene tetrafluoride-perfluoroalkoxyethylene copolymer (PFA), polyvinylidene fluoride (PVDF), Teflon (registered trademark), Viton (registered trademark), Kalrez (registered trademark), and the like.

### Examples

The present invention will next be described in more detail with reference to Examples and Comparative Examples. First, nitrosyl fluorides containing nitryl fluoride, which is an impurity, at various concentrations were prepared. Preparation Examples of nitrosyl fluoride will be described below.

### (Preparation Example 1)

A container made of stainless steel (SUS304L) having a capacity of 500 mL was filled with 0.43 mol of nitrosyl fluoride under the conditions of a temperature of 20°C and a pressure of 2.07 MPa, and a sample obtained by extracting the gas phase portion of this nitrosyl fluoride was used as nitrosyl fluoride of Preparation Example 1. The concentration of nitryl fluoride in the nitrosyl fluoride of this Preparation Example 1 was measured, and it was 4217 ppm by mass.

The concentration of nitryl fluoride was measured by using an infrared spectrophotometer Nicolet iS10 manufactured by Thermo Fisher Scientific, Inc. and a cell having an optical path length of 10 cm. That is, an infrared spectroscopic analysis was performed by causing the nitrosyl fluoride of Preparation Example 1 to flow into a cell at a flow rate of 200 sccm by using a mass flow controller, and the concentration of nitryl fluoride was quantitatively determined by means of the intensity of an absorption peak at a wave number of 1310 cm⁻¹ in the obtained infrared absorption spectrum.

### (Preparation Example 2)

Nitrosyl fluoride of Preparation Example 2 was obtained by subjecting nitrosyl fluoride prepared in the same manner as in Preparation Example 1 to a nitryl fluoride removal treatment of removing nitryl fluoride present at a high concentration in the gas phase portion to reduce the concentration of nitryl fluoride in the nitrosyl fluoride of the liquid phase portion. That is, the nitryl fluoride removal treatment was carried out by cooling a stainless steel container to -55°C, and extracting and removing the gas phase portion of nitrosyl fluoride for 60 seconds from the stainless steel container through a nitrogen gas-based flow rate controller in which the flow rate was set to 1000 sccm. After the gas phase portion was removed, the temperature was returned to normal temperature, and then the gas phase portion of nitrosyl fluoride remaining in the stainless steel container was extracted and used as nitrosyl fluoride of Preparation Example 2. The concentration of nitryl fluoride in the nitrosyl fluoride of Preparation Example 2 was measured in the same manner as in the case of Preparation Example 1, and the concentration was 2083 ppm by mass.

### (Preparation Example 3)

Nitrosyl fluoride of Preparation Example 3 was obtained by performing the treatment in exactly the same manner as in Preparation Example 2, except that the time for extracting the gas phase portion of nitrosyl fluoride from the stainless steel container was set to 90 seconds. The concentration of nitryl fluoride in the nitrosyl fluoride of Preparation Example 3 was measured in the same manner as in the case of Preparation Example 1, and the concentration was 901 ppm by mass.

### (Preparation Example 4)

Nitrosyl fluoride of Preparation Example 4 was obtained by performing the treatment in exactly the same manner as in Preparation Example 2, except that the time for extracting the gas phase portion of nitrosyl fluoride from the stainless steel container was set to 105 seconds. The concentration of nitryl fluoride in the nitrosyl fluoride of Preparation Example 4 was measured in the same manner as in the case of Preparation Example 1, and the concentration was 459 ppm by mass.

### (Preparation Example 5)

Nitrosyl fluoride of Preparation Example 5 was obtained by performing the treatment in exactly the same manner as in Preparation Example 2, except that the time for extracting the gas phase portion of nitrosyl fluoride from the stainless steel container was set to 120 seconds. The concentration of nitryl fluoride in the nitrosyl fluoride of Preparation Example 5 was measured in the same manner as in the case of Preparation Example 1, and the concentration was 58 ppm by mass.

### (Preparation Example 6)

Nitrosyl fluoride of Preparation Example 6 was obtained by performing the treatment in exactly the same manner as in Preparation Example 2, except that the time for extracting the gas phase portion of nitrosyl fluoride from the stainless steel container was set to 135 seconds. The concentration of nitryl fluoride in the nitrosyl fluoride of Preparation Example 6 was measured in the same manner as in the case of Preparation Example 1, and the concentration was 5 ppm by mass.

### (Preparation Example 7)

Nitrosyl fluoride of Preparation Example 7 was obtained by performing the treatment in exactly the same manner as in Preparation Example 2, except that the time for extracting the gas phase portion of nitrosyl fluoride from the stainless steel container was set to 150 seconds. The concentration of nitryl fluoride in the nitrosyl fluoride of Preparation Example 7 was measured in the same manner as in the case of Preparation Example 1, and the concentration was 0.08 ppm by mass.

By further lengthening the time for extracting the gas phase portion of nitrosyl fluoride from the stainless steel container (time for the nitryl fluoride removal treatment), it was expected that it is possible to obtain nitrosyl fluoride having a lower concentration of nitryl fluoride; however, preparation was not performed because the concentration of nitryl fluoride was 0.001 ppm by mass or less, which is the detection limit of the analytical instrument.

### (Preparation Example 8)

A container made of stainless steel (SUS304L) having a capacity of 500 mL and filled with the nitrosyl fluoride of Preparation Example 7 was prepared. Furthermore, another container made of stainless steel (SUS304L) having a capacity of 500 mL was filled with trifluoroamine-N-oxide (F₃NO), and these two stainless steel containers were connected. The stainless steel container filled with the nitrosyl fluoride of Preparation Example 7 was cooled to -100°C, and a nitrogen gas-based flow rate controller in which the flow rate was set to 1000 sccm was joined to the connection parts of both the stainless steel containers. Then, trifluoroamine-N-oxide was supplied for 60 seconds from the stainless steel container filled with trifluoroamine-N-oxide to the stainless steel container filled with the nitrosyl fluoride of Preparation Example 7.

The connection between the two stainless steel containers was released, the temperature was returned to normal temperature, subsequently a gas phase portion of the content was extracted from the stainless steel container in which trifluoroamine-N-oxide was caused to flow into the nitrosyl fluoride of Preparation Example 7, and this extracted gas phase portion was used as nitrosyl fluoride of Preparation Example 8. The concentration of trifluoroamine-N-oxide in the nitrosyl fluoride of Preparation Example 8 was measured, and the concentration was 2381 ppm by mass. Furthermore, the concentration of nitryl fluoride in the nitrosyl fluoride of Preparation Example 8 was measured, and the concentration was 24 ppm by mass.

The concentration of trifluoroamine-N-oxide was measured by using an infrared spectrophotometer Nicolet iS10 manufactured by Thermo Fisher Scientific, Inc. That is, the concentration of trifluoroamine-N-oxide was quantitatively determined by means of the intensity of a peak at a wave number of 1690 cm⁻¹ in the obtained infrared absorption spectrum.

### (Preparation Example 9)

Nitrosyl fluoride of Preparation Example 9 was obtained by performing the treatment in exactly the same manner as in Preparation Example 8, except that the time for supplying trifluoroamine-N-oxide was set to 120 seconds. The concentration of trifluoroamine-N-oxide in the nitrosyl fluoride of Preparation Example 9 was measured in the same manner as in the case of Preparation Example 8, and the concentration was 4872 ppm by mass. Furthermore, the concentration of nitryl fluoride in this nitrosyl fluoride of Preparation Example 9 was measured, and the concentration was 48 ppm by mass.

### (Example 1)

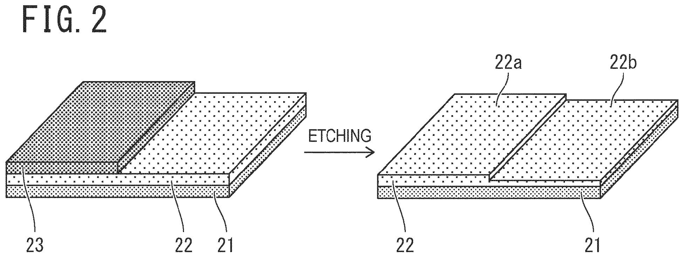

Etching of a member to be etched was performed by using an etching apparatus having a configuration substantially similar to the configuration of the etching apparatus in FIG. 1. The member to be etched used in Example 1 will be described with reference to FIG. 2.

A substrate (manufactured by Seiren KST Corporation) was prepared by forming a silicon nitride film 22 having a film thickness of 1 um on a square-shaped silicon substrate 21 that measured 2 inches on each side, a rectangular-shaped silicon dioxide substrate 23 having dimensions of 1 inch x 2 inches was adhered on the silicon nitride film 22 using grease (DEMNUM GREASE L-200 manufactured by Daikin Industries, Ltd.), and a laminate produced in this manner was used as the member to be etched. The silicon dioxide substrate 23 was adhered so as to cover a portion of approximately half of the silicon nitride film 22, as illustrated in FIG. 2. The silicon nitride film 22 is the etching object, and the silicon dioxide substrate 23, which is a non-etching object, is used as a resist.

Furthermore, in the above-described member to be etched, a comparative laminate was produced in which the silicon nitride film 22 as the etching object was replaced with a film of silicon dioxide, which was a non-etching object.

The above-described member to be etched and the comparative laminate were placed side by side on a stage inside the chamber of the etching apparatus, and the temperature of the stage was raised to 150°C.

Next, a mixed gas was obtained by mixing the nitrosyl fluoride gas of Preparation Example 7 at a flow rate of 100 mL/min with argon at a flow rate of 900 mL/min, and this mixed gas was used as an etching gas. Then, this etching gas was supplied to the inside of the chamber at a flow rate of 500 mL/min and caused to flow therethrough for 30 minutes to perform etching. The pressure inside the chamber during the flow of the etching gas was set to 10 kPa, and the partial pressure of the nitrosyl fluoride gas was set to 1 kPa.

As a result, an exposed portion in the silicon nitride film 22 of the member to be etched, which portion was not covered with the silicon dioxide substrate 23, was etched. When flowing of the etching gas was finished, heating of the stage was terminated, and the inside of the chamber was purged with argon. The concentration of nitryl fluoride in the argon used here was measured, and nitryl fluoride was not detected.

When etching was finished, the chamber was opened to take out the member to be etched, the silicon dioxide substrate 23 was removed from the member to be etched that was taken out, and the surface of adhesion was cleaned with ethanol to remove grease. Then, the size of the level difference between a cover surface 22a of the silicon nitride film 22, which was covered by the silicon dioxide substrate 23 and was not etched, and an etched surface 22b of the silicon nitride film 22, which was not covered by the silicon dioxide substrate 23 and was etched, was measured by using an atomic force microscope VN-8010 manufactured by Keyence Corporation. The etching rate (nm/min) of silicon nitride was calculated by dividing the measured size (nm) of the level difference by the etching time (min). The results are shown in Table 1.

Furthermore, the comparative laminate was also subjected to an operation similar to that for the member to be etched, and the etching rate (nm/min) of silicon dioxide was calculated by dividing the size (nm) of the level difference by the etching time (min). In addition, a ratio of the etching rate of silicon dioxide with respect to the etching rate of silicon nitride (etching selectivity ratio) was calculated. The results are shown in Table 1.

The measurement conditions for the size of the level difference using an atomic force microscope were as follows.
Measurement pressure: Atmospheric pressure (101.3 kPa)
Measurement temperature: 28°C
Measurement atmosphere: In air
Scan range: Width 80.0 um, height 20.0 um, angle 0°

### (Examples 2 to 7 and Comparative Examples 1 and 2)

Etching of the member to be etched was performed in the same manner as in Example 1, except that the nitrosyl fluorides of Preparation Examples 1 to 6, 8, and 9 were used instead of the nitrosyl fluoride of Preparation Example 7, and the etching rate of silicon nitride, the etching rate of silicon dioxide, and the etching selectivity ratio were calculated, respectively. The results are shown in Table 1.

### (Examples 8 to 12)

Etching of the member to be etched was performed in the same manner as in Example 1, except that the nitrosyl fluoride used was as described in Table 1, and that the etching conditions (stage temperature and pressure inside the chamber) were set as described in Table 1, and the etching rate of silicon nitride, the etching rate of silicon dioxide, and the etching selectivity ratio were calculated, respectively. The results are shown in Table 1.

**[Table 1]**

| | Etching gas | | | | Stage temperature (°C) | Pressure inside chamber (Pa) | Etching rate (nm/min) | | Etching selectivity ratio |
|---|---|---|---|---|---|---|---|---|---|
| | Preparation Example | NO₂F removal treatment¹⁾ | Concentration²⁾ of NO₂F | Concentration²⁾ of F₃NO | | | Silicon nitride | Silicon oxide | |
| Ex. 1 | 7 | 150 | 0.008 | 3.1 | 150 | 10000 | 6.06 | 0.08 | 75.8 |
| Ex. 2 | 6 | 135 | 0.5 | 3.1 | 150 | 10000 | 6.05 | 0.08 | 74.7 |
| Ex. 3 | 5 | 120 | 5.8 | 3.1 | 150 | 10000 | 6.03 | 0.08 | 73.6 |
| Ex. 4 | 4 | 105 | 45.9 | 3.1 | 150 | 10000 | 5.97 | 0.09 | 66.4 |
| Ex. 5 | 3 | 90 | 90.1 | 3.2 | 150 | 10000 | 5.83 | 0.10 | 60.1 |
| Comp. Ex. 1 | 2 | 60 | 208.3 | 3.2 | 150 | 10000 | 5.65 | 0.11 | 52.3 |
| Comp. Ex. 2 | 1 | 0 | 421.7 | 3.4 | 150 | 10000 | 5.63 | 0.11 | 50.3 |
| Ex. 6 | 8 | 150 | 2.4 | 238.1 | 150 | 10000 | 6.01 | 0.08 | 74.2 |
| Ex. 7 | 9 | 150 | 4.8 | 487.2 | 150 | 10000 | 5.98 | 0.08 | 72.9 |
| Ex. 8 | 7 | 150 | 0.008 | 3.1 | 300 | 50000 | 66.4 | 0.27 | 242.3 |
| Ex. 9 | 6 | 135 | 0.5 | 3.1 | 300 | 50000 | 65.9 | 0.27 | 240.5 |
| Ex. 10 | 5 | 120 | 5.8 | 3.1 | 300 | 50000 | 65.6 | 0.28 | 233.5 |
| Ex. 11 | 4 | 105 | 45.9 | 3.1 | 300 | 50000 | 65.2 | 0.32 | 205.7 |
| Ex. 12 | 3 | 90 | 90.1 | 3.2 | 300 | 50000 | 62.0 | 0.35 | 175.1 |

| | | | | | | | | | |
|---|---|---|---|---|---|---|---|---|---|
| 1) The unit for the values is seconds. 2) The unit for the values is ppm by mass. | | | | | | | | | |

From the results shown in Table 1, it is understood that in Examples 1 to 7 in which the concentration of nitryl fluoride in the etching gas is 100 ppm by mass or less, the etching selectivity ratio, which is the ratio of the etching rate of silicon nitride with respect to the etching rate of silicon oxide, is higher in comparison with Comparative Examples 1 and 2 in which the concentration is more than 100 ppm by mass.

Furthermore, it is understood that even when trifluoroamine-N-oxide is contained in nitrosyl fluoride, trifluoroamine-N-oxide does not affect the etching selectivity ratio as much as nitryl fluoride does.

In addition, it is understood that the etching rate of silicon nitride and the etching selectivity ratio are improved along with increases in the temperature of the stage and the pressure in the chamber.

### Reference Signs List

- 1: nitrosyl fluoride gas supply unit
- 2: diluent gas supply unit
- 3: nitrosyl fluoride gas flow rate controller
- 4: diluent gas flow rate controller
- 5: nitrosyl fluoride gas supply pipe
- 6: diluent gas supply pipe
- 7: nitrosyl fluoride gas pressure controller
- 8: diluent gas pressure controller
- 10: chamber
- 11: stage
- 12: member to be etched
- 13: exhaust pipe
- 14: thermometer
- 15: vacuum pump
- 16: pressure gauge
- 21: silicon substrate
- 22: silicon nitride film
- 23: silicon dioxide substrate

## Claims

1. An etching gas comprising nitrosyl fluoride,
wherein the etching gas contains nitryl fluoride as an impurity and has a concentration of nitryl fluoride of 0.0001 ppm by mass or more and 100 ppm by mass or less.

2. A method for producing the etching gas according to claim 1, the method comprising:
a nitryl fluoride removal step of subjecting crude nitrosyl fluoride, which is nitrosyl fluoride containing nitryl fluoride, to a nitryl fluoride removal treatment of removing nitryl fluoride.

3. An etching method comprising:
an etching step of bringing the etching gas according to claim 1 into contact with a member to be etched having an etching object, which is an object of etching by the etching gas, and a non-etching object, which is not an object of etching by the etching gas, and selectively etching the etching object in comparison with the non-etching object, wherein the etching object contains silicon nitride.

4. The etching method according to claim 3,
wherein the etching gas is a gas consisting of nitrosyl fluoride alone, or a mixed gas containing nitrosyl fluoride and a diluent gas.

5. The etching method according to claim 3,
wherein the diluent gas is at least one selected from nitrogen gas, helium, argon, neon, krypton, and xenon.

6. A method for producing a semiconductor element for producing a semiconductor element by using the etching method according to any one of claims 3 to 5,
wherein the member to be etched is a semiconductor substrate having the etching object and the non-etching object, and
the method includes a treatment step of removing at least a portion of the etching object from the semiconductor substrate by the etching.
